# EUROPEAN PATENT APPLICATION

(11) **EP 4 391 774 A2**
(43) Date of publication of application: **26.06.2024**
(21) Application number: 23180559.9
(22) Date of filing: 21.06.2023
(51) Int. Cl.: H10K 59/124, H10K 59/131, H10K 59/80

(54) **ORGANIC LIGHT-EMITTING DIODE DISPLAY DEVICE**

(30) Priority: 20.12.2022 KR 20220179787
(71) Applicant: LG Display Co., Ltd., Seoul 07336 (KR)
(72) Inventor: HAN, Joon-Soo, 245, LG-ro, Wollong-Myeon, Paju-si, Gyeonggi-do, 10845 (KR); KIM, Dae-Hyun, 245, LG-ro, Wollong-Myeon, Paju-si, Gyeonggi-do, 10845 (KR); HU, Jae-Sung, 245, LG-ro, Wollong-Myeon, Paju-si, Gyeonggi-do, 10845 (KR)
(74) Representative: Bryn-Jacobsen, Caelia

(57) **Abstract**

An organic light-emitting diode display device can include a substrate including sub-pixels associated with one pixel, each sub-pixel having an emission area and a non-emission area; first conductive lines and a second conductive line over the substrate, wherein the second conductive line crosses over the first conductive lines to define the sub-pixels; a circuit portion in the non-emission area of each sub-pixel, and including a thin film transistor in each sub-pixel; an overcoat layer over the thin film transistors and including micro lenses in the emission area of each sub-pixel; and a light-emitting diode in the emission area of each sub-pixel over the overcoat layer, and connected to the corresponding thin film transistor. For a first sub-pixel among the sub-pixels, the overcoat layer can have a depressed pattern corresponding to the non-emission area of the first sub-pixel and overlapping one of the first conductive lines.

## Description

### CROSS-REFERENCE TO RELATED APPLICATION

The present application claims priority to Korean Patent Application No. 10-2022-0179787 filed in the Republic of Korea on December 20, 2022.

### BACKGROUND

### Field of the Disclosure

The present disclosure relates to a display device, and more particularly, to an organic light-emitting diode display device.

### Discussion of the Background Art

As the information society progresses, a demand for different types of display devices increases, and flat panel display devices (FPD) such as liquid crystal display devices (LCD) and organic light-emitting diode display devices (OLED) have been developed and applied to various fields.

Among the flat panel display devices, organic light-emitting diode display devices, which are also referred to as organic electroluminescent display devices, emit light due to the radiative recombination of an exciton. The exciton is formed from an electron and a hole by injecting charges into a light-emitting layer between a cathode for injecting electrons and an anode for injecting holes in a light-emitting diode.

The organic light-emitting diode display device can be formed over a flexible substrate, such as plastic, and offers various advantages and improved properties. For instance, because it is self-luminous, the organic light-emitting diode display device has an excellent contrast ratio and an ultra-thin thickness, and has a response time of several micro seconds. As such, there are advantages in displaying moving images and videos without delays using the organic light-emitting diode display device.

Additionally, the organic light-emitting diode display device has a wide viewing angle and is stable under low temperatures. Further, since the organic light-emitting diode display device is generally driven by a low voltage of direct current (DC) (e.g., 5V to 15V), it is easy to design and manufacture the driving circuits of the organic light-emitting display device.

On the other hand, in the process of light generated in the light-emitting layer of the organic light-emitting diode display device passing through various components and being emitted to the outside, if some light is not emitted to the outside due to total internal reflection at the interface between the components, the light extraction efficiency is reduced, which leads to decrease the luminance and increase the power consumption.

Further, a process of ensuring that the layers in the organic light-emitting diode display device are properly formed would be desirable, so as to increase production efficiency as well as performance yield.

### SUMMARY OF THE DISCLOSURE

Accordingly, the present disclosure is to provide an organic light-emitting diode display device that substantially obviates one or more of the limitations and disadvantages described above and associated with the background art.

More specifically, an object of the present disclosure is to provide an organic light-emitting diode display device with improved light extraction efficiency by having micro lenses.

Another object of the present disclosure is to provide an organic light-emitting diode display device capable of efficiently manufacturing and managing micro lenses.

Additional features and aspects will be set forth in the description that follows, and in part will be apparent from the description, or can be learned by practice of the present disclosure provided herein. Other features and aspects of the inventive concepts can be realized and attained by the structure particularly pointed out in the written description, or derivable therefrom, and the claims hereof as well as the appended drawings.

To achieve these and other aspects of the present disclosure, as embodied and broadly described herein, an organic light-emitting diode display device includes a substrate including at least one sub-pixel having an emission area and a non-emission area; at least one first conductive layer (or line) and at least one second conductive layer (or line) over the substrate and crossing each other to define the at least one sub-pixel; a circuit portion in the non-emission area and including a thin film transistor; an overcoat layer over the thin film transistor and including a plurality of micro lenses in the emission area; and a light-emitting diode in the emission area over the overcoat layer and connected to the thin film transistor, wherein the overcoat layer has a depressed pattern corresponding to the non-emission area and overlapping the at least one first conductive layer.

An organic light-emitting diode display device according to an aspect of the present disclosure can include a substrate including a plurality of sub-pixels associated with one pixel, each sub-pixel having an emission area and a non-emission area; a plurality of first conductive lines and a second conductive line over the substrate, wherein the second conductive line crosses over the plurality of first conductive lines to define the plurality of sub-pixels; a circuit portion in the non-emission area of each sub-pixel, and including a thin film transistor in each sub-pixel; an overcoat layer over the thin film transistors, and including a plurality of micro lenses in the emission area of each sub-pixel; and a light-emitting diode in the emission area of each sub-pixel over the overcoat layer, and connected to the corresponding thin film transistor, wherein for a first sub-pixel among the plurality of sub-pixels, the overcoat layer has a depressed pattern corresponding to the non-emission area of the first sub-pixel and overlapping one of the plurality of first conductive lines.

An organic light-emitting diode display device according to an aspect of the present disclosure can include a pixel including a plurality of sub-pixels over a substrate, wherein each sub-pixel includes an emission area and a non-emission area; a plurality of thin film transistors respectively provided in the non-emission areas of the plurality of sub-pixels; a plurality of color filters respectively provided in the emission areas of the plurality of sub-pixels; an overcoat layer provided over the plurality of color filters and the plurality of thin film transistors; a bank including a plurality of openings, the plurality of openings respectively provided in the emission areas of the plurality of sub-pixels; and a plurality of micro lenses provided at top surfaces of the overcoat layer, wherein in a first sub-pixel among the plurality of sub-pixels, micro-lenses that are provided at the top surfaces of the overcoat layer do not fill the entire opening corresponding to the first sub-pixel, while in all other sub-pixels, micro-lenses provided at the top surfaces of the overcoat layer fill the entire openings corresponding to the all other sub-pixels.

It is to be understood that both the foregoing general description and the following detailed description are examples and are intended to provide further explanation of the inventive concepts as claimed.

### BRIEF DESCRIPTION OF THE DRAWINGS

The accompanying drawings, which are included to provide a further understanding of the present disclosure and which are incorporated in and constitute a part of this application, illustrate aspects of the disclosure and together with the description serve to explain various principles of the present disclosure.

In the drawings:
FIG. 1 is an example of an equivalent circuit diagram of one sub-pixel of an organic light-emitting diode display device according to an example of the present disclosure;
FIG. 2 is a schematic cross-sectional view of the organic light-emitting diode display device according to the example of the present disclosure;
FIG. 3 is a schematic plan view of an organic light-emitting diode display device according to a first example of the present disclosure;
FIG. 4 is a cross-sectional view corresponding to the line I-I' of FIG. 3;
FIG. 5 is a cross-sectional view corresponding to the line II-II' of FIG. 3;
FIGS. 6A to 6D are cross-sectional views of an organic light-emitting diode display device for explaining a method of manufacturing the organic light-emitting diode display device according to the first example of the present disclosure;
FIG. 7 is a schematic plan view of an organic light-emitting diode display device according to a second example of the present disclosure; and
FIG. 8 is a schematic plan view of an organic light-emitting diode display device according to a third example of the present disclosure.

### DETAILED DESCRIPTION OF THE EXAMPLES

Advantages and features of the present disclosure and methods for achieving them will be made clear from examples described in detail below with reference to the accompanying drawings. The present disclosure can, however, be implemented in many different forms and should not be construed as being limited to the examples set forth herein, and the examples are provided such that this disclosure will be thorough and complete and will fully convey the scope of the present disclosure to those skilled in the art to which the present disclosure pertains.

Shapes, sizes, ratios, angles, numbers, and the like disclosed in the drawings for describing the examples of the present disclosure are illustrative, and thus the present disclosure is not limited to the illustrated matters. The same reference numerals refer to the same components throughout this disclosure. Further, in the following description of the present disclosure, when a detailed description of a known related art is determined to unnecessarily obscure the gist of the present disclosure, the detailed description thereof will be omitted herein or may be briefly discussed.

When terms such as "including," "having," "comprising" and the like mentioned in this disclosure are used, other parts can be added unless the term "only" is used herein. Further, when a component is expressed as being singular, being plural is included unless otherwise specified.

In analyzing a component, an error range is interpreted as being included even when there is no explicit description.

In describing a positional relationship, for example, when a positional relationship of two parts/layers is described as being "over," "on," "above," "below," "under," "next to," or the like, one or more other parts/layers can be provided between the two parts/layers, unless the term "immediately" or "directly" is used therewith.

In describing a temporal relationship, for example, when a temporal predecessor relationship is described as being "after," "subsequent," "next to," "prior to," or the like, unless "immediately" or "directly" is used, cases that are not continuous or sequential can also be included.

Although the terms first, second, and the like are used to describe various components, these components are not substantially limited by these terms. These terms are used only to distinguish one component from another component, and may not define any order or sequence. Therefore, a first component described below can substantially be a second component within the technical scope of the present disclosure.

Features of various examples of the present disclosure can be partially or entirely united or combined with each other, technically various interlocking and driving are possible, and each of the examples can be independently implemented with respect to each other or implemented together in a related relationship.

Hereinafter, example examples of the present disclosure will be described in detail with reference to accompanying drawings. All the components of each organic light-emitting diode display device according to all examples of the present disclosure are operatively coupled and configured. For example, although some components of the organic light-emitting diode display devices may not specifically described herein, the organic light-emitting diode display devices of the present disclosure include such components to fully and functionally operate.

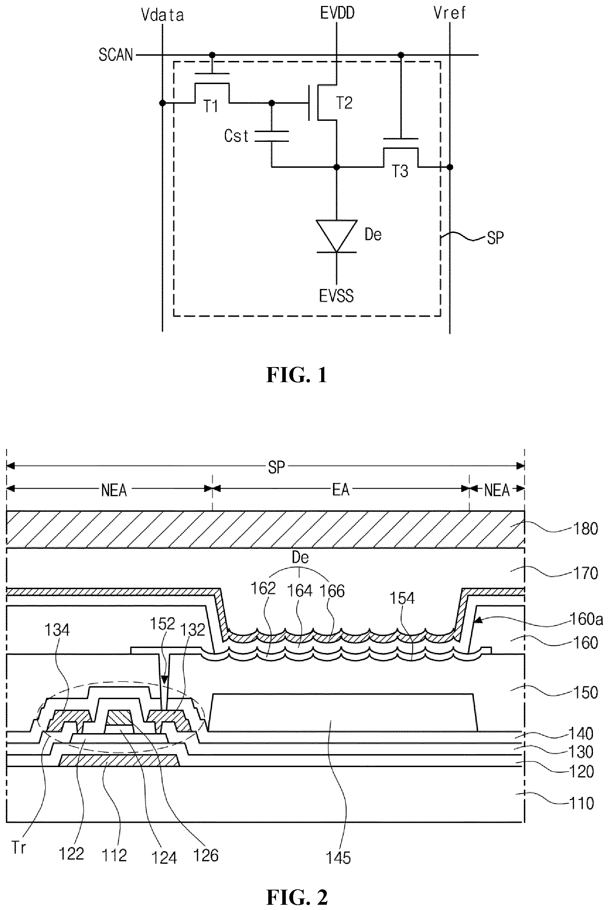

An organic light-emitting diode display device according to examples of the present disclosure includes a plurality of pixels arranged in the form of a matrix in a display area, and each pixel includes a plurality of sub-pixels. Each sub-pixel has the same or substantially the same configuration as other sub-pixels, and one example of the configuration of such sub-pixel will be described with reference to FIG. 1 and FIG. 2, but other configurations are possible.

FIG. 1 is an example of an equivalent circuit diagram of one sub-pixel of an organic light-emitting diode display device according to an example of the present disclosure.

In FIG. 1, a sub-pixel SP of the organic light-emitting diode display device according to the example of the present disclosure can include first, second, and third transistors T1, T2, and T3, a storage capacitor Cst, and a light-emitting diode De. The first, second, and third transistors T1, T2, and T3 can be a switching transistor T1, a driving transistor T2, and a sensing transistor T3, respectively. The switching transistor T1, the driving transistor T2, and the sensing transistor T3 can be n-type transistors. However, the present disclosure is not limited thereto. Alternatively, the switching transistor T1, the driving transistor T2, and the sensing transistor T3 can be p-type transistors or other types of transistors.

A gate line supplying a scan signal (or gate signal) SCAN and a data line supplying a data signal Vdata can cross each other, and the switching transistor T1 can be disposed at a crossing point of the gate line and the data line. A gate of the switching transistor T1 can be connected to the gate line to receive the gate signal SCAN, and a drain of the switching transistor T1 can be connected to the data line to receive the data signal Vdata.

In addition, a gate of the driving transistor T2 can be connected to a source of the switching transistor T1 and a first capacitor electrode of the storage capacitor Cst. A drain of the driving transistor T2 can be connected to a high potential line supplying a high potential voltage EVDD, and a source of the driving transistor T2 can be connected to an anode of the light-emitting diode De, a second capacitor electrode of the storage capacitor Cst, and a source of the sensing transistor T3.

A gate of the sensing transistor T3 can be connected to the gate line, and a drain of the sensing transistor T3 can be connected to a reference line supplying a reference voltage Vref. Alternatively, the gate of the sensing transistor T3 can be connected to a separate sensing line.

Here, source and drain locations of each of the transistors T1, T2, and T3 are not limited thereto, and the locations can be interchanged or varied.

Meanwhile, a cathode of the light-emitting diode De can be connected to a low potential line supplying a low potential voltage EVSS. Alternatively, the cathode of the light-emitting diode De can be connected to a ground voltage.

During an emission period of one frame, the switching transistor T1 can be switched according to the gate signal SCAN transmitted through the gate line to thereby provide the gate of the driving transistor T2 with the data signal Vdata transmitted through the data line. The driving transistor T2 can be switched according to the data signal Vdata to thereby control a current of the light-emitting diode De. In this case, the storage capacitor Cst can maintain charges corresponding to the data signal Vdata for one frame. Accordingly, even if the switching transistor T1 is turned off, the storage capacitor Cst can allow the amount of the current flowing through the light-emitting diode De to be constant and the gray level shown by the light-emitting diode De to be maintained until a next frame.

In addition, one frame can further include a sensing period. During the sensing period, the sensing transistor T3 can be switched according to the gate signal SCAN transmitted through the gate line to thereby provide the source of the driving transistor T2 with the reference voltage Vref. The sensing transistor T3 can detect the voltage change of the source of the driving transistor T2 through the reference line and can calculate the threshold voltage Vth of the driving transistor T2 by comparing the amount of the voltage change with a determination range. Accordingly, by calculating the threshold voltage Vth in real time and compensating for the image data, it is possible to compensate for the change in the characteristics of the driving transistor T2 and prevent image degradation.

FIG. 2 is a schematic cross-sectional view of the organic light-emitting diode display device according to the example of the present disclosure. A cross-section corresponding to one sub-pixel is shown, and a bottom emission-type organic light-emitting diode display device will be described as an example and other variations are possible.

In FIG. 2, the organic light-emitting diode display device according to the example of the present disclosure can include a plurality of sub-pixels each having a substrate 110, a thin film transistor Tr, and a light-emitting diode De.

A sub-pixel SP having an emission area EA and a non-emission area NEA can be provided over the substrate 110. The light-emitting diode De can be disposed in the emission area EA, and the thin film transistor Tr can be disposed in the non-emission area NEA.

Specifically, a light-shield layer 112 can be disposed in the non-emission area NEA over the substrate 10. The substrate 110 can be formed of a transparent insulating material. For example, the substrate 110 can be a glass substrate or a plastic substrate. Polyimide can be used for the plastic substrate, but the examples of the present disclosure are not limited thereto.

The light-shielding layer 112 can be formed of at least one of aluminum (Al), copper (Cu), molybdenum (Mo), titanium (Ti), chromium (Cr), nickel (Ni), tungsten (W), or an alloy thereof and can have a single-layer structure or a multi-layer structure. For example, the light-shielding layer 112 can have a double-layer structure including a lower layer of a molybdenum-titanium (MoTi) alloy and an upper layer of copper (Cu), and the upper layer can have a thicker thickness than the lower layer. However, the examples of the present disclosure are not limited thereto.

A buffer layer 120 of an insulating material can be placed over the light-shielding layer 112. The buffer layer 120 can be disposed over substantially an entire surface of the substrate 110. The buffer layer 120 can be formed of an inorganic material such as silicon oxide (SiO₂) or silicon nitride (SiNx) and can have a single-layer structure or a multi-layer structure.

A semiconductor layer 122 can be patterned and placed over the buffer layer 120. The semiconductor layer 122 can overlap the light-shielding layer 112. The semiconductor layer 122 can be formed of an oxide semiconductor material. In this situation, the light-shielding layer 112 can block light incident on the semiconductor layer 122, thereby preventing the semiconductor layer 122 from being degraded due to the light.

Alternatively, the semiconductor layer 122 can be formed of polycrystalline silicon. In this situation, both ends of the semiconductor layer 122 can be doped with impurities.

A gate insulation layer 124 and a gate electrode 126 can be sequentially placed over the semiconductor layer 122. The gate insulation layer 124 and the gate electrode 126 can be disposed to correspond to a central portion of the semiconductor layer 122. The gate insulation layer 124 can be pattern to have substantially the same shape as the gate electrode 126. Alternatively, the gate insulation layer 124 can be disposed over substantially the entire surface of the substrate 110.

The gate insulation layer 124 can be formed of an inorganic insulating material such as silicon oxide (SiO₂) or silicon nitride (SiNx). Here, when the semiconductor layer 122 is formed of an oxide semiconductor material, the gate insulation layer 124 can be formed of silicon oxide (SiO₂). Alternatively, when the semiconductor layer 122 is formed of polycrystalline silicon, the gate insulation layer 124 can be formed of silicon oxide (SiO₂) or silicon nitride (SiNx).

The gate electrode 126 can be formed of a conductive material such as metal. For example, the gate electrode 126 can be formed of at least one of aluminum (Al), copper (Cu), molybdenum (Mo), titanium (Ti), chromium (Cr), nickel (Ni), tungsten (W), or an alloy thereof and can have a single-layer structure or a multi-layer structure. For example, the gate electrode 126 can have a double-layer structure including a lower layer of a molybdenum-titanium (MoTi) alloy and an upper layer of copper (Cu), and the upper layer can have a thicker thickness than the lower layer. However, the examples of the present disclosure are not limited thereto.

An interlayer insulation layer 130 of an insulating material can be disposed over the gate electrode 126 over substantially the entire surface of the substrate 110. The interlayer insulation layer 130 can be formed of an inorganic insulating material, such as silicon oxide (SiO₂) or silicon nitride (SiNx), or can be formed of an organic insulating material, such as photo acryl or benzocyclobutene.

The interlayer insulation layer 130 can have semiconductor contact holes exposing top surfaces of both ends of the semiconductor layer 122. The semiconductor contact holes can be disposed at both sides of the gate electrode 126 and can be spaced apart from the gate electrode 126.

Next, source and drain electrodes 132 and 134 of a conductive material such as metal can be placed over the interlayer insulation layer 130.

The source and drain electrodes 132 and 134 can be formed of at least one of aluminum (Al), copper (Cu), molybdenum (Mo), titanium (Ti), chromium (Cr), nickel (Ni), tungsten (W), or an alloy thereof and can have a single-layer structure or a multi-layer structure. For example, each of the source and drain electrodes 132 and 134 can have a double-layer structure including a lower layer of a molybdenum-titanium (MoTi) alloy and an upper layer of copper (Cu), and the upper layer can have a thicker thickness than the lower layer. Alternatively, the source and drain electrodes 132 and 134 can have a triple-layer structure. However, the examples of the present disclosure are not limited thereto.

The source and drain electrodes 132 and 134 can be spaced apart from each other with the gate electrode 126 interposed therebetween and can be in contact with the both ends of the semiconductor layer 122 through the semiconductor contact holes.

The semiconductor layer 122, the gate electrode 126, the source electrode 132, and the drain electrode 134 can constitute a thin film transistor Tr. Here, the thin film transistor Tr can have a coplanar structure in which the gate electrode 126 and the source and drain electrodes 132 and 134 are disposed at the same side with respect to the semiconductor layer 122, for example, the gate electrode 126 and the source and drain electrodes 132 and 134 can be disposed over the semiconductor layer 122.

Alternatively, the thin film transistor Tr can have an inverted staggered structure in which the gate electrode and the source and drain electrodes are disposed at different sides with respect to the semiconductor layer, for example, the gate electrode can be disposed under the semiconductor layer and the source and drain electrodes can be disposed over the semiconductor layer. In this case, the semiconductor can be formed of an oxide semiconductor material or amorphous silicon.

However, the examples of the present disclosure are not limited thereto. The stacked structure of the components of the thin film transistor Tr can be varied.

The thin film transistor Tr can be the driving transistor T2 of FIG. 1. Meanwhile, at least one thin film transistor having the same structure as the thin film transistor Tr, for example, the switching transistor T1 of FIG. 1 and the sensing transistor T3 of FIG. 1 can be further formed in the non-emission area NEA over the substrate 110. However, the examples of the present disclosure are not limited thereto. Alternatively, at least one thin film transistor having a different structure from the thin film transistor Tr can be further provided in the non-emission area NEA over the substrate 110.

A passivation layer 140 of an insulating material can be disposed over the source and drain electrodes 132 and 134 as well ass the gate electrode 126 over substantially the entire surface of the substrate 110. The passivation layer 140 can be formed of an inorganic insulating material, such as silicon oxide (SiO₂) or silicon nitride (SiNx).

A color filter 145 can be placed over the passivation layer 140. The color filter 145 can be placed to correspond to the emission area EA and can be one of red, green, and blue color filters.

An overcoat layer 150 of an insulating material can be disposed over the color filter 145 over substantially the entire surface of the substrate 110. The overcoat layer 150 and the passivation layer 140 can have a source contact hole 152 exposing the source electrode 132.

The overcoat layer 150 can be formed of an organic insulating material. For example, the overcoat layer 150 can be formed of photo acryl. However, the examples of the present disclosure are not limited thereto.

The overcoat layer 150 can include a plurality of micro lenses 154 at a top surface thereof in the emission area EA. The plurality of micro lenses 154 can constitute a micro lens array (MLA), and each of the plurality of micro lenses 154 can have a depressed portion. Here, adjacent portions of two micro lenses 154 can form an embossed portion, and each depressed portion can be surrounded by the embossed portion. Accordingly, the micro lens array can be configured such that the depressed portion and the embossed portion can be alternately disposed or the micro lenses 154 can have other shapes and configurations.

Meanwhile, the overcoat layer 150 can have substantially a flat top surface in the non-emission area NEA.

A first electrode 162 of a conductive material having a relatively high work function can be placed over the overcoat layer 150 in the emission area EA. For example, the first electrode 162 can be formed of a transparent conductive material, such as indium tin oxide (ITO) or indium zinc oxide (IZO), but examples are not limited thereto.

The first electrode 162 can be extended into the non-emission area NEA and can be in contact with the source electrode 132 through the source contact hole 152.

In the emission area EA, the first electrode 162 can be formed along the morphology or contour of the top surface of the overcoat layer 150 including the micro lenses 154. Accordingly, the first electrode 162 can have an uneven top surface.

A bank 160 of an insulating material can be placed over the first electrode 162. The bank 160 can be formed of an organic insulating material. The bank 160 can overlap and cover edges of the first electrode 162. The bank 160 can have an opening 160a corresponding to the emission area EA, and a central portion of the first electrode 162 can be exposed through the opening 160a.

Next, a light-emitting layer 164 can be placed over the first electrode 162 exposed through the opening 160a of the bank 160. The light-emitting layer 164 can be disposed over substantially the entire surface of the substrate 110. Accordingly, in the emission area EA, the light-emitting layer 164 can be disposed over the first electrode 162 and in contact with the first electrode 162. In the non-emission area NEA, the light-emitting layer 164 can be disposed over the bank 160 and in contact with a top surface of the bank 160. Further, the light-emitting layer 164 can be in contact with a side surface of the bank 160.

The light-emitting layer 164 can emit white light and can include at least one hole auxiliary layer, at least one light-emitting material layer, and at least hole electron auxiliary layer, which constitute one light-emitting unit. The hole auxiliary layer can include at least one of a hole injection layer (HIL) and a hole transport layer (HTL). In addition, the electron auxiliary layer can include at least one of an electron injection layer (EIL) and an electron transport layer (ETL).

The light-emitting layer 164 can have a stack structure in which two or more light-emitting units emitting different colors are stacked, and a charge generation layer can be provided between two or more light-emitting units.

In the emission area EA, the light-emitting layer 164 can be formed along the morphology or contour of the top surface of the first electrode 162. Accordingly, in the emission area EA, the light-emitting layer 164 can be formed substantially along the morphology or contour of the top surface of the overcoat layer 150, and the light-emitting layer 164 can have an uneven top surface.

A second electrode 166 of a conductive material, having a relatively low work function, can be placed over the light-emitting layer 164 over substantially the entire surface of the substrate 110. In the emission area EA, the second electrode 166 can be disposed over the first electrode 162 and the light-emitting layer 164, and in the non-emission area NEA, the second electrode 166 can be disposed over the bank 160 and the light-emitting layer 164.

The second electrode 166 can be formed of aluminum, magnesium, silver, or an alloy thereof.

In the emission area EA, the second electrode 166 can be formed along the morphology or contour of the top surface of the light-emitting layer 164. Accordingly, in the emission area EA, the second electrode 166 can be formed substantially along the morphology or contour of the top surface of the overcoat layer 150 including the micro lenses 154, and the second electrode 166 can have an uneven top surface.

Here, the light-emitting layer 164 can have different thicknesses depending on the position. For example, a thickness of a portion of the light-emitting layer 164 corresponding to the depressed portion of the micro lens 154 can be thicker than a thickness of a portion of the light-emitting layer 164 corresponding to the embossed portion where two micro lenses 154 are adjacent to each other, and the light-emitting layer 164 can have the thinnest thickness between the depressed portion and the embossed portion.

The first electrode 162, the light-emitting layer 164, and the second electrode 166 can constitute the light-emitting diode De. Here, the first electrode 162 can function as an anode, and the second electrode 166 can function as a cathode, but the examples are not limited thereto.

The first electrode 162 can be formed of a transparent conductive material transmitting light, and the second electrode 166 can be formed of a metal material reflecting light. Accordingly, light from the light-emitting layer 164 can be emitted through the first electrode 162 and can pass through the color filter 145 and the substrate 110 to be output to the outside.

An encapsulation layer 170 can be placed over the second electrode 166 over substantially the entire surface of the substrate 110. The encapsulation layer 170 can be in the form of a face seal made of an organic or inorganic insulating material that is transparent and has adhesive properties or can have a multi-layer structure in which an inorganic layer, an organic layer, and an inorganic layer are stacked.

A counter substrate 180 can be placed over the encapsulation layer 170. The counter substrate 180 can be a glass substrate or a metal substrate. Alternatively, the counter substrate 180 can be formed in the form of a film.

The encapsulation layer 170 and the counter substrate 180 can prevent substances such as moisture, dust or oxygen from being introduced into the light-emitting diode De from the outside or prevent an external impact from being applied to the light-emitting diode De.

As described above, the overcoat layer 150 can have the plurality of micro lenses 154 at the top surface thereof in the emission area EA, and the first electrode 162, the light-emitting layer 164, and the second electrode 166 placed over the overcoat layer 150 can be formed substantially along the morphology or contour of the top surface of the overcoat layer 150. Accordingly, in the emission area EA, the first electrode 162, the light-emitting layer 164, and the second electrode 166 can have uneven patterns corresponding to the micro lenses 154 of the overcoat layer 150. Further, in the emission area EA, the first electrode 162, the light-emitting layer 164, and the second electrode 166 can also have micro lenses.

The micro lenses 154 can improve the light extraction efficiency by changing the progress path of light so that the light, which was completely reflected and extinguished after being emitted from the light-emitting layer, can be extracted to the outside.

Meanwhile, the micro lenses 154 have a very small size in micro units, and the size and shape of the micro lenses 154 directly affect the luminance. Thus, it is rather important to manage the size and shape of the micro lenses 154.

Accordingly, the organic light-emitting diode display device according to the examples of the present disclosure can include a depressed pattern capable of monitoring the micro lens such as the formation of the micro lens.

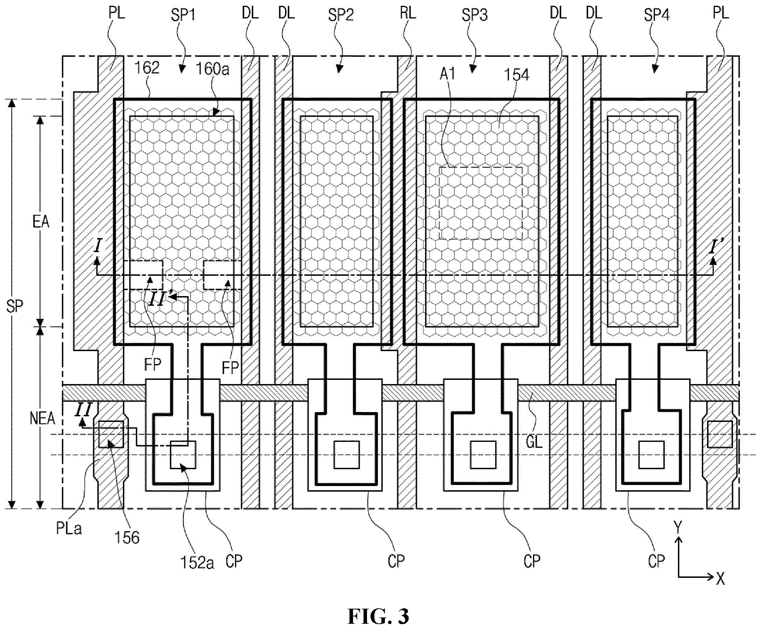

FIG. 3 is a schematic plan view of an organic light-emitting diode display device according to a first example of the present disclosure, showing one pixel and will be described with reference to FIG. 1 and FIG. 2 together.

As shown in FIG. 3, in the organic light-emitting diode display device according to the first example of the present disclosure, a gate line GL can extend along a first direction, which is the X direction, and data lines DL, power lines PL, and a reference line RL can extend along a second direction, which is the Y direction. The gate line GL can cross the data line DL, the power line PL, and the reference line RL to thereby define a plurality of sub-pixels SP. Here, the power line PL can be the high potential line supplying the high potential voltage EVDD of FIG. 1.

Here, one reference line RL can be disposed between two power lines PL, two data lines DL can be disposed between one power line PL and one reference line RL, and each sub-pixel SP can be disposed substantially between one power line PL and one adjacent data line DL or between one reference line RL and one adjacent data line DL.

Each sub-pixel SP can have substantially a rectangular shape. However, the examples of the present disclosure are not limited thereto, and the shape of each sub-pixel SP can be changed.

As described above, one pixel can include a plurality of such sub-pixels SP. For example, one pixel can include four sub-pixels SP, for example, first, second, third, and fourth sub-pixels SP1, SP2, SP3, and SP4. The first, second, third, and fourth sub-pixels SP1, SP2, SP3, and SP4 can be sequentially arranged along the first direction. Here, the first sub-pixel SP1 can be a red sub-pixel, the second sub-pixel SP2 can be a blue sub-pixel, the third sub-pixel SP3 can be a white sub-pixel, and the fourth sub-pixel SP4 can be a green sub-pixel. However, the examples of the present disclosure are not limited thereto. Alternatively, the number of sub-pixels included in one pixel or the arrangement order of the red, green, blue, and white sub-pixels can be changed.

The areas or sizes of the first, second, third, and fourth sub-pixels SP1, SP2, SP3, and SP4 can be different from each other. For example, the areas of the first and third sub-pixels SP1 and SP3 can be larger than the areas of the second and fourth sub-pixels SP2 and SP4. In addition, the area of the third sub-pixel SP3 can be equal to or larger than the area of the first sub-pixel SP1, and the area of the second sub-pixel SP2 can be equal to or larger than the area of the fourth sub-pixel SP4. However, the examples of the present disclosure are not limited thereto. Alternatively, all areas or sizes of the first, second, third, and fourth sub-pixels SP1, SP2, SP3, and SP4 can be the same or substantially the same.

Here, one power line PL, two data lines DL, or one reference line RL can be disposed substantially between adjacent two of the sub-pixels SP1, SP2, SP3, and SP4. For example, two data lines DL can be disposed between the first and second sub-pixels SP1 and SP2 and between the third and fourth sub-pixels SP3 and SP4, one reference line RL can be disposed between the second and third sub-pixels SP2 and SP3, and one power line PL can be disposed between the first sub-pixel SP1 and a fourth sub-pixel SP4 of a previous pixel and between the fourth sub-pixel SP4 and a first sub-pixel SP1 of a next pixel. However, the examples of the present disclosure are not limited thereto.

Each sub-pixel SP can include the emission area EA and the non-emission area NEA. The light-emitting diode De of FIG. 1 can be provided in the emission area EA, and a circuit portion CP can be provided in the non-emission area NEA. The light-emitting diode De can include the first electrode 162, which is an anode, and the circuit portion CP can include the first, second, and third transistors T1, T2, and T3 and the storage capacitor Cst of FIG. 1.

The first electrode 162 can extend into the non-emission area NEA and can be electrically connected to the circuit portion CP. More particularly, the first electrode 162 can be electrically connected to the second transistor T2 of the circuit portion CP through a contact hole 152a. The contact hole 152a can be the source contact hole exposing the source electrode of the second transistor T2. The first electrode 162 can be in contact with the source electrode of the second transistor T2 through the contact hole 152a.

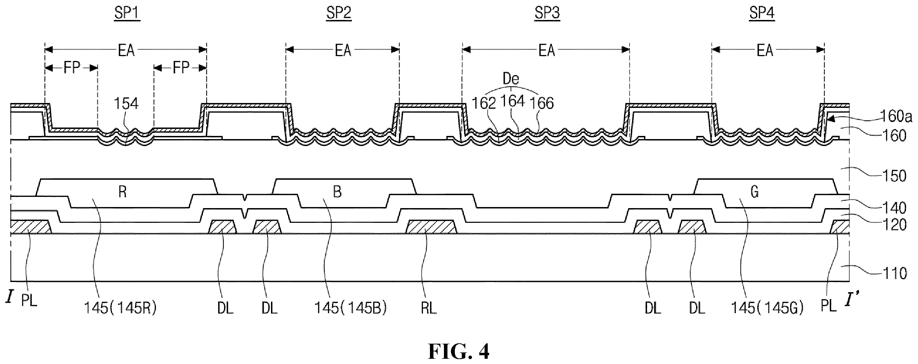

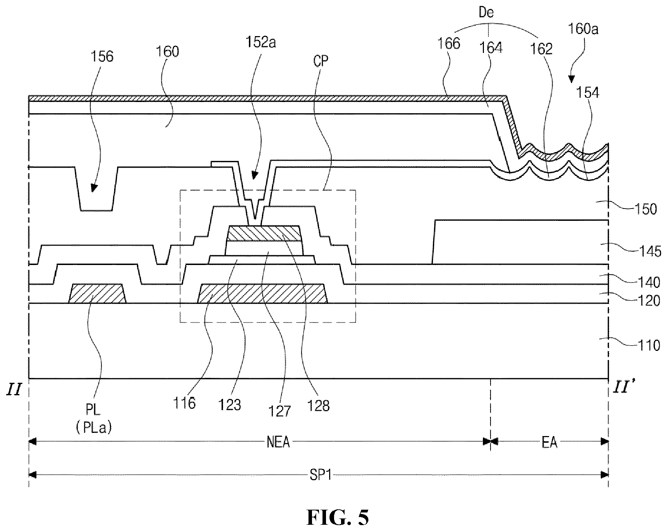

The emission area EA can be defined by the opening 160a of the bank (e.g., 160 in FIGS. 4 and 5) exposing the first electrode 162. The opening 160a of the bank can have a smaller area than the first electrode 162 and can be disposed within the edges of the first electrode 162.

Here, each of the power lines PL, the data lines DL, and the reference line RL can overlap the first electrode 162 corresponding thereto and can be spaced apart from the opening 160a of the bank corresponding thereto. In this case, each of the power lines PL and the reference line RL can include a portion overlapping the first electrode 162, which has a wider width than other portions of the corresponding power line PL or reference line RL. However, the examples of the present disclosure are not limited thereto.

A plurality of micro lenses 154 can be provided in the emission area EA of each sub-pixel SP. The micro lenses 154 can be placed inside the opening 160a of the bank but also outside the opening 160a and can overlap the bank. Meanwhile, the micro lenses 154 can overlap the first electrode 162 and can be spaced apart from the edges of the first electrode 162 without overlapping.

The micro lenses 154 can have a hexagonal shape in plan and can form a honeycomb structure. Alternatively, the micro lenses 154 can have a circular shape, an oval shape, a rectangular shape, or the like.

Meanwhile, in the organic light-emitting diode display device according to the first example of the present disclosure, at least one sub-pixel SP can include at least one flat portion FP in the emission area EA. For instance, in each pixel, there can be at least one sub-pixel SP each with at least one flat portion FP.

In this example, the first sub-pixel SP1 can have two flat portions FP in the emission area EA. The two flat portions FP can be placed at both sides of the emission area EA facing each other along the first direction, respectively, and can be disposed on the same straight line. Here, the phrase `on a straight line' is interchangeably used with `in a straight line'.

Two flat portions FP can be used advantageously for measuring the size of the opening 160a of the bank.

The size of the emission area EA and the number of micro lenses 154 can be determined according to the size of the opening 160a of the bank. When the size of the opening 160a is smaller than a set range, the number of micro lenses 154 contributing to the light extraction can be reduced, thereby decreasing or adjusting the light extraction efficiency. Accordingly, it is necessary to manage the size of the opening 160a within a specific range.

Here, the size of the opening 160a can be measured by photographing an optical image of the patterned bank, but the optical image can be distorted due to the micro lenses 154. Accordingly, in the first example of the present disclosure, the flat portions FP where the micro lenses 154 are not substantially placed can be provided in the emission area EA, and the boundary of the opening 160a can be disposed over the flat portions FP, so that the size of the opening 160a of the bank and the distance between the openings 160, for example, the width of the bank, can be accurately measured without distortion of the gray level.

In an example, each flat portion FP can be greater than or equal to the area of four micro lenses 154 while be smaller than or equal to the area of nine micro lenses 154, but the examples of the present disclosure are not limited thereto.

Meanwhile, a depressed pattern (or depression or concave portion) 156 can be provided over each power line PL corresponding to the non-emission area NEA. In this case, the power line PL can include a protrusion PLa in the non-emission area NEA. The protrusion PLa can have a wider width than other portions of the power line PL, and the depressed pattern 156 can be disposed over to correspond with the protrusion PLa.

The depressed pattern 156 and the contact hole 152a can have substantially a rectangular shape. However, the examples of the present disclosure are not limited thereto, and the depressed pattern 156 and/or the contact hole 152a can have various shapes.

In addition, the size of the depressed pattern 156 can be different from the size of the contact hole 152a. Alternatively, the size of the depressed pattern 156 can be the same as the size of the contact hole 152a.

The depressed pattern 156 can be disposed on a different straight line from the contact hole 152a. For instance, a virtual straight line passing through the centers of the depressed patterns 156 adjacent along the first direction does not coincide with a virtual straight line passing through the centers of the contact holes 152a adjacent along the first direction, and two virtual straight lines are spaced apart from each other along the second direction.

The depressed pattern 156 can be used for monitoring the micro lenses 154, and this will be described in detail later.

The cross-sectional structure of the organic light-emitting diode display device according to the first example of the present disclosure will be described with reference to FIG. 4 and FIG. 5.

FIG. 4 is a cross-sectional view corresponding to the line I-I' of FIG. 3, and FIG. 5 is a cross-sectional view corresponding to the line II-II' of FIG. 3.

In FIG. 4 and FIG. 5, the substrate 110 can include the plurality of sub-pixels, for example, the first, second, third, and fourth sub-pixels SP1, SP2, SP3, and SP4. The power lines PL, the data lines DL, and the reference line RL, which are a first conductive layer, can be placed over the substrate 110. The buffer layer 120 and the passivation layer 140 can be sequentially placed over the power lines PL, the data lines DL, and the reference line RL. The gate line GL, which is a second conductive layer, can be placed between the buffer layer 120 and the passivation layer 140.

Meanwhile, the circuit portion CP can be placed in the non-emission area NEA of each sub-pixel SP1, SP2, SP3, and SP4 over the substrate 110. The circuit portion CP can include at least one first conductive pattern 116 provided between the substrate 110 and the buffer layer 120 and at least one second conductive pattern 128 provided between the buffer layer 120 and the passivation layer 140. In addition, the circuit portion CP can further include a semiconductor pattern 123 provided between the buffer layer 120 and the second conductive pattern 128. In this case, an insulation layer 127, which is patterned to have the same shape as the second conductive pattern 128, can be placed under the second conductive pattern 128 and above the semiconductor pattern 123, and the insulation layer 127 can be a gate insulation layer.

The first conductive pattern 116, the semiconductor pattern 123, and the second conductive pattern 128 can overlap each other.

The first conductive pattern 116 can be formed of the same material and over the same layer as the power line PL, the data line DL, and the reference line RL, and the second conductive pattern 128 can be formed of the same material and over the same layer as the gate line GL.

Here, the first conductive pattern 116 can be a light-shielding layer (e.g., like the light shieling layer 112 in FIG. 2), and the second conductive pattern 128 can be the source of the driving transistor T2 of FIG. 1. However, the examples of the present disclosure are not limited thereto.

Next, the color filter 145 can be placed over the passivation layer 140 corresponding to the emission area EA. Here, a portion of the color filter 145 can be extended into the non-emission area NEA.

The color filter 145 can include red, green, and blue color filters 145R, 145G, and 145B. The red color filter 145R can be disposed in the first sub-pixel SP1, the blue color filter 145B can be disposed in the second sub-pixel SP2, and the green color filter 145G can be disposed in the fourth sub-pixel SP4. No color filter can be disposed in the third sub-pixel SP3 which can be a white sub-pixel.

The color filter 145 can overlap the lines adjacent thereto. For instance, the red color filter 145R can overlap one power line PL and adjacent one data line DL, the blue color filter 145B can overlap another data line DL and the reference line RL, and the green color filter 145G can overlap another data line DL and another power line PL.

Although FIG. 4 shows that the red, blue, and green color filters 145R, 145B, and 145G are spaced apart from each other, the examples of the present disclosure are not limited thereto. Alternatively, adjacent ones of the red, blue, and green color filters 145R, 145B, and 145G can overlap each other. For example, adjacent red and blue color filters 145R and 145B can overlap each other, and adjacent green and red color filters 145G and 145R can overlap each other.

The overcoat layer 150 can be placed over the color filter 145. The overcoat layer 150 can have the plurality of micro lenses 154 at the top surface thereof in the emission area EA of each sub-pixel SP1, SP2, SP3, and SP4.

In the first, second, and fourth sub-pixels SP1, SP2, and SP4, the micro lenses 154 can overlap the color filter 145. Each micro lens 154 can include the depressed portion, and adjacent portions of two or more micro lenses 154 can form the embossed portion.

Meanwhile, the emission area EA of the first sub-pixel SP1 can include at least one flat portion FP. As an example, the emission area EA of the first sub-pixel SP1 can include two flat portions FP in FIG. 3, and the flat portions FP can be disposed at both sides of the emission area EA facing each other. No lens pattern is not provided in the flat portions FP. The top surface of the overcoat layer 150 corresponding to the flat portions FP can be flat or substantially flat without any micro lens or lens pattern.

In addition, the overcoat layer 150 can have the contact hole 152a and the depressed pattern 156 in the non-emission area NEA.

The contact hole 152a of the overcoat layer 150 can be provided in each of the first, second, third, and fourth sub-pixels SP1, SP2, SP3, and SP4. The contact hole 152a can also be provided in the passivation layer 140 to expose the second conductive pattern 128 under the passivation layer 140. In this case, a width of the contact hole 152a provided in the overcoat layer 150 can be greater than a width of the contact hole 152a provided in the passivation layer 140.

Meanwhile, the depressed pattern 156 of the overcoat layer 150 can be provided in one sub-pixel, for example, in the first sub-pixel SP1. The depressed pattern 156 can be disposed to correspond to the power line PL. The depressed pattern 156 can overlap the power line PL and can have a narrower width than the power line PL. For example, the depressed pattern 156 can overlap the protrusion PLa of the corresponding power line PL and can have a narrower width than the protrusion PLa of the power line PL.

Here, a depth of the depressed pattern 156 can be smaller than a thickness of the overcoat layer 150. Further, the depth of the depressed pattern 156 can be smaller than a depth of the contact hole 152a, and can be equal to or larger than the height of the protrusion PLa.

Next, the first electrode 162 of the light-emitting diode De can be placed over the overcoat layer 150 in each of the first, second, third, and fourth sub-pixels SP1, SP2, SP3, and SP4. The first electrode 162 can overlap and cover the micro lenses 154. In addition, the first electrode 162 can be extended into the non-emission area NEA and be in contact with the second conductive pattern 128 through the contact hole 152a.

The bank 160 can be provided over the first electrode 162. The bank 160 can have the opening 160a corresponding to the emission area EA of each sub-pixel SP1, SP2, SP3, and SP4. The first electrode 162 can be exposed through the opening 160a.

The bank 160 can overlap the micro lenses 154 in each of the first, second, third, and fourth sub-pixels SP1, SP2, SP3, and SP4. Here, the bank 160 can overlap a portion of the micro lens 154. In the first sub-pixel SP1, the bank 160 can overlap the micro lenses 154 in an outer area except for the flat portions FP.

Meanwhile, in the first sub-pixel SP1, two side surfaces of the bank 160 facing each other can be disposed over the two flat portions FP, respectively. For instance, the opening 160a (defined by the two opposite side surfaces of the bank 160) can be disposed over the the two flat portions FP. Further, the two side surfaces of the bank 160 facing each other can be spaced apart from the micro lenses 154 without overlapping.

As a variation for the micro lenses 154, micro lenses can be provided at the overcoat layer where the overcoat layer can be composed of multiple overcoat layers stacked vertically on top of each other. Further, such multiple overcoat layers can have different refractive indices from each other. For instance, two overcoat layers having different refractive indices can be vertically stacked on top of each other, and the micro lenses with curved patterns can be provided at the boundary of (or within) the two stacked overcoat layers.

In one example, the bottom overcoat layer among the two vertically stacked overcoat layers can have micro lenses at the top surface of the bottom overcoat layer. Then the top overcoat layer among the two vertically stacked overcoat layers can be disposed on and cover/fill the bottom overcoat layer including the micro lenses. As such, the top surface of the top overcoat layer can be flat entirely (e.g., in the entire opening 160a of the bank), and the first electrode 162, the light-emitting layer 164 and the second electrode 166 of the light-emitting diode De can be disposed on the entirely flat top surface of the top overcoat layer. In that case, the flat portions FP (with flat surfaces) where the micro lenses are located between the flat portions FP, can be provided at the boundary of the two vertically stacked overcoat layers.

Returning to the example of FIGS. 4 and 5, the light-emitting layer 164 of the light-emitting diode De can be placed over the first electrode 162 and the bank 160. The light-emitting layer 164 can be disposed over substantially the entire surface of the substrate 110. The light-emitting layer 164 can emit white light and can have a stack structure, which includes light-emitting units emitting different colors.

The second electrode 166 can be placed over the light-emitting layer 164. The second electrode 166 can be disposed over substantially the entire surface of the substrate 110.

The first electrode 162, the second electrode 166, and the light-emitting layer 164 interposed therebetween can constitute the light-emitting diode De.

As described above, the overcoat layer 150 can have the micro lenses 154 at its top surface in the emission area EA. The first electrode 162, the light-emitting layer 164, and the second electrode 166 disposed over the overcoat layer 150 can be formed along the morphology or contour of the top surface of the overcoat layer 150. Accordingly, the first electrode 162, the light-emitting layer 164, and the second electrode 166 can also have the micro lens shape at the respective top surfaces in the emission area EA, and the micro lenses 154 can change the progress path of light, thereby improving the light extraction efficiency.

In addition, the top surface of the overcoat layer 150 can have the flat portions FP in the emission area EA, and the side surfaces of the bank 160 can be disposed over the flat portions FP to non-overlap and/or to be spaced apart from the micro lenses 154, so that the size of the opening 160a and the width of the bank 160 can be accurately measured without distortion of the gray level. Therefore, since the opening 160a of the bank 160 can be managed with a specific range, it is possible to prevent the light extraction efficiency of the display device from being lowered.

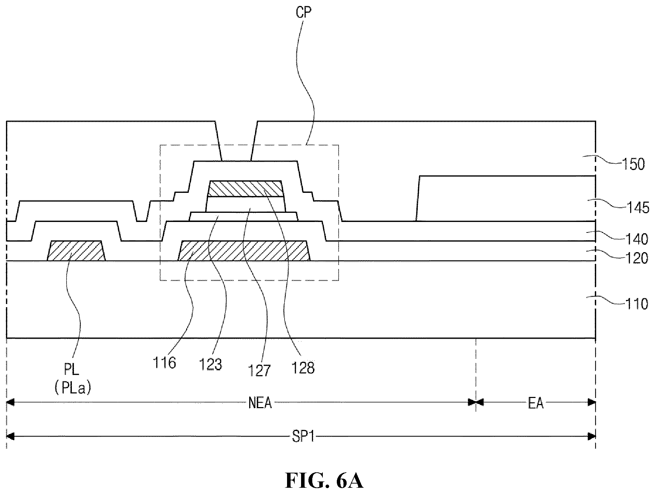

As described above, the depressed pattern 156 of the overcoat layer 150 in the non-emission area NEA can be used for monitoring the micro lenses 154. This will be described with reference to FIGS. 6A to 6D.

FIGS. 6A to 6D are cross-sectional views of an organic light-emitting diode display device in steps of a process of manufacturing the same according to the first example of the present disclosure and show a cross-section corresponding to the first sub-pixel. Particularly, FIGS. 6A to 6D show the process of forming the display device shown in FIG. 5.

In FIG. 6A, the power line PL, the circuit portion CP, the buffer layer 120, and the passivation layer 140 can be formed over the substrate 110 provided with the first sub-pixel SP1 including the emission area NE and the non-emission area NEA. Here, the power line PL and the circuit portion CP can be disposed in the non-emission area NEA, and the buffer layer 120 and the passivation layer 140 can be disposed over substantially the entire surface of the substrate 110. The circuit portion CP can include at least one first conductive pattern 116, at least one semiconductor pattern 123, and at least one second conductive pattern 128. In addition, the insulation layer 127 can be further provided under the second conductive pattern 128 and above the semiconductor pattern 123, and the insulation layer 127 can be a gate insulation layer.

Then, the color filter 145 can be formed over the passivation layer 140 in the emission area EA, and the overcoat layer 150 can be formed over the color filter 145. Here, the portion of the color filter 145 can be extended into the non-emission area NEA, and the overcoat layer 150 can be formed over substantially the entire surface of the substrate 110. In addition, the overcoat layer 150 can expose the top surface of the passivation layer 140 corresponding to the second conductive pattern 128 of the circuit portion CP.

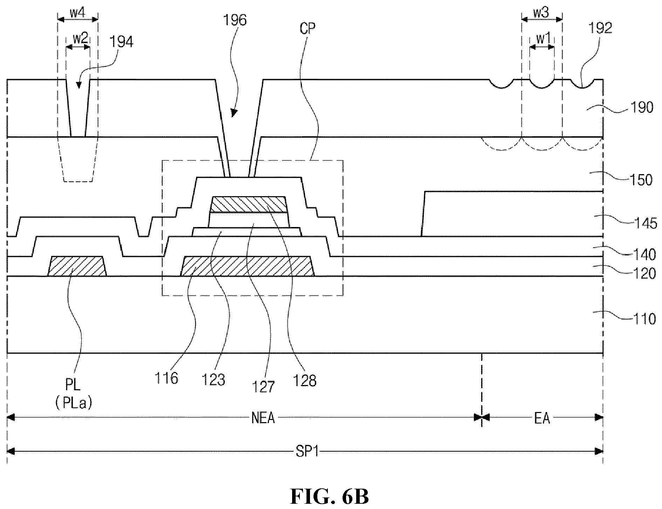

Next, in FIG. 6B, photoresist can be applied over the overcoat layer 150, and the photoresist can be exposed to light through a photolithography process using a photo mask and developed, thereby forming a photoresist layer 190 having a plurality of first patterns 192, a second pattern 194, and a third pattern 196 at or through the top surface thereof. The first patterns 192 can have a concave shape at the top surface of the photoresist layer 190, and the second pattern 194 and the third pattern 196 can have a hole shape (e.g., thru-hole) that penetrates from the top surface to the bottom surface of the photoresist layer 190.

Here, the photoresist can have the positive photosensitivity in which a portion exposed to light is removed after developing. However, the examples of the present disclosure are not limited thereto.

The plurality of first patterns 192 can be formed in the emission area EA, and the second pattern 194 and the third pattern 196 can be formed in the non-emission area NEA.

The first patterns 192 can be disposed to correspond to the micro lenses (to be formed) indicated by a dotted line at the top surface of the overcoat layer 150. The second pattern 194 can be disposed to correspond to the depressed pattern (to be formed) indicated by a dotted line at the top surface of the overcoat layer 150 and can expose the top surface of the overcoat layer 150 corresponding to the protrusion PLa of the power line PL.

The first and second patterns 192 and 194 can have first and second widths w1 and w2, respectively. Here, the first width w1 of the first pattern 192 can be smaller than a third width w3 of the micro lens (154 to be formed), and the second width w2 of the second pattern 194 can be smaller than a fourth width w4 of the depressed pattern (156 to be formed). The second width w2 of the second pattern 194 can be greater than the first width w1 of the first pattern 192, and the fourth width w4 of the depressed pattern can be greater than the third width w3 of the micro lens.

Meanwhile, the third pattern 196 can be formed to correspond to the circuit portion CP and can expose the top surface of the passivation layer 140, which is exposed by the overcoat layer 150 corresponding to the second conductive pattern 128. Here, the photoresist layer 190 can cover and contact the side surfaces of the overcoat layer 150.

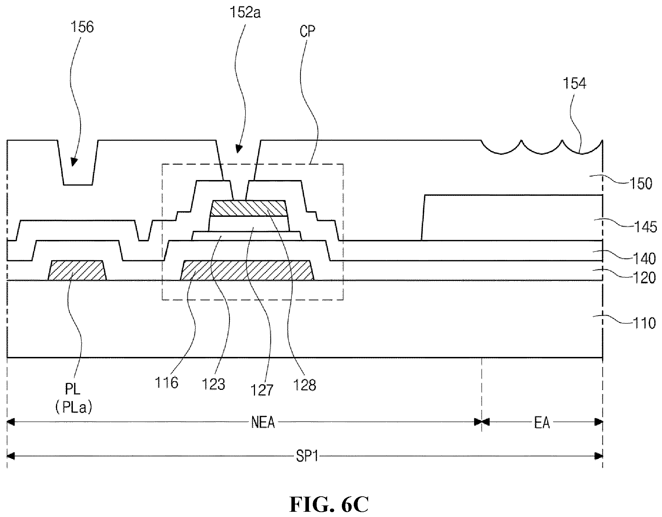

Next, in FIG. 6C, the photoresist layer 190 can be removed by sequentially performing an ashing process and a wet etching process, thereby forming the plurality of micro lenses 154 and the depressed pattern 156 at the top surface of the overcoat layer 150. In addition, the passivation layer 140 exposed by the overcoat layer 150 can be selectively removed, thereby forming the contact hole 152a exposing the second conductive pattern 128.

The plurality of micro lenses 154 can be provided in the emission area EA, and the depressed pattern 156 can be provided in the non-emission area NEA to correspond to the protrusion Pla of the power line PL.

Then, the micro lenses 154 can be monitored by measuring the depressed pattern 156. Here, it can be difficult to accurately measure the contact hole 152a, which is formed together with the depressed pattern 156, because the contact hole 152a has a deeper depth than the depressed pattern 156 and interference can occur by various layers provided thereunder.

The measurement of the depressed pattern 156 can be performed using optical equipment. The uniformity according to dispersion can be measured by measuring the size and shape of the depressed pattern 156 for each location in the entire display area (e.g., NEA's). In addition, the remaining thickness of the overcoat layer 150 can be measured, thereby monitoring the micro lenses 154.

In this case, the line made of a metal material, specifically, the protrusion Pla of the power line PL, can be disposed under the depressed pattern 156. Since the metal line is better flattened than the insulation layer, the measurement noise can be reduced, and the consistency can be improved. In addition, since the metal line reflects light, the depressed pattern 156 can be easily measured using reflectance.

Further, the power line PL has a relatively large area compared to other lines, so that the depressed pattern 156 can be formed more easily.

Meanwhile, as described above, the depressed pattern 156 and the contact hole 152a can be offset from each other and located on different straight lines, so that the probability of mismeasurement by the contact hole 152a can be lowered and the recognition accuracy can be improved.

According to the present disclosure, the formation of the micro lenses 154 (which can be difficult to monitor) can be monitored based on the monitoring of the depressed pattern 156. For instance, if the measured size and shape of the depressed pattern 156 are within the set range and are uniformly formed over the entire display area, then it can be assumed or inferred that the micro lenses 154 are uniformly formed with the desired size and shape. As a result, a subsequent process can be carried out.

On the other hand, if the measured size and shape of the depressed pattern 156 are not within the set range or are not uniformly formed over the entire display area, then it can be viewed that the micro lenses 154 may not have the desired size and shape and/or may not have been non-uniformly formed, so the overcoat layer 150 currently formed may be removed.

In such a case, the overcoat layer 150 and the photoresist layer 190 can be sequentially formed through rework, the micro lenses 154 and the depressed pattern 156 can be formed through the ashing process and the like, and the size and shape of the depressed pattern 156 can be measured again.

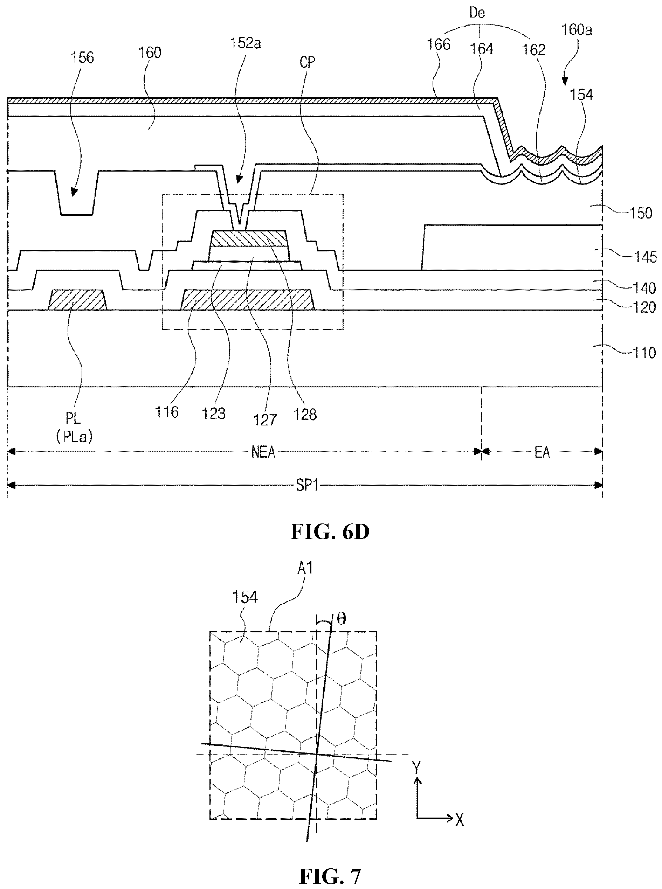

Next, when the measured size and shape of the depressed pattern 156 are determined to be within the set range, as shown in FIG. 6D, the light-emitting diode De and the bank 160 can be formed over the overcoat layer 150 including the micro lenses 154 and the depressed pattern 156. Specifically, the first electrode 162 can be formed over the overcoat layer 150 in the emission area EA, the bank 160 with the opening 160a exposing the first electrode 162 can be formed over the first electrode 162, and the light-emitting layer 164 and the second electrode 166 can be sequentially formed over the exposed first electrode 162 and the bank 160.

In the emission area EA, the overcoat layer 150 can have the micro lenses 154, and the first electrode 162, the light-emitting layer 164, and the second electrode 166 can be formed along the morphology or contour of the top surface of the overcoat layer 150. Accordingly, the first electrode 162, the light-emitting layer 164, and the second electrode 166 can also have the micro lens shape in the emission area EA.

As such, in the organic light-emitting diode display device according to the first example of the present disclosure, the formation of the micro lenses 154 can be monitored by placing the depressed pattern 156 over the power line PL in the non-emission area NEA through the same process as the micro lenses 154, and it is possible to measure the process/formation capability after completing the formation of the micro lenses 154 so that the manufacturing of the micro lenses 154 can be more efficiently managed and controlled.

Since rework is possible through the monitoring, pattern consistency of the micro lenses 154 can be improved. Accordingly, the light extraction efficiency can be improved, and the power consumption can be reduced to implement the low power consumption.

In addition, since the yield of the display device can be improved by the rework and process management through the monitoring, the production energy can be reduced, and the process optimization can be implemented. Furthermore, production hazards and regulated substances can be reduced, and thus it can be helpful for recycling.

By placing the depressed pattern 156 over the line made of a metal material as the power line PL, the depressed pattern 156 can be easily measured using the reflectance during measurement, and the measurement noise can be reduced due to the flatness of the line, which is relatively higher than that of the insulation layer, thereby improving the consistency.

Additionally, the depressed pattern 156 and the contact hole 152a can be spaced apart from each other and disposed on different straight lines, thereby reducing the probability of mismeasurement due to any confusion.

Meanwhile, in another example of the present disclosure, the micro lenses in at least one sub-pixel can be provided to be rotated. Such a second example of the present disclosure will be described with reference to FIG. 7. The second example is substantially the same as the first example, but the micro lenses in at least one sub-pixel can be rotated.

FIG. 7 is a schematic plan view of an organic light-emitting diode display device according to the second example of the present disclosure and is an enlarged view corresponding to the area A1 of FIG. 3. The first to fourth sub-pixels can be sequentially provided over the substrate 110.

In FIG. 7, the micro lenses 154 provided in at least one sub-pixel can be rotated clockwise or counterclockwise with respect to the first and second directions. Here, the first direction is the X direction, and the second direction is the Y direction.

For example, the micro lenses 154 can be rotated clockwise with an angle θ with respect to the first and second directions. Accordingly, the line connecting the centers of the micro lenses 154 adjacent to each other can have the angle θ with respect to the first and/or second direction.

Here, the angle θ can be selected from a range greater than or equal to 0 degrees and less than 60 degrees. For instance, the rotation angle of the micro lenses 154 can be between 0 to 60 degrees in the clockwise or counterclockwise direction.

Further, the micro lenses 154 of all or some sub-pixels can be rotated. In this case, the micro lenses 154 of the adjacent sub-pixels can have different rotation angles.

For example, the micro lenses 154 in twenty sub-pixels arranged in a matrix form can be rotated clockwise or counterclockwise with a rotation angle of 3 degree difference and randomly arranged. However, the examples of the present disclosure are not limited thereto.

As such, in the organic light-emitting diode display device according to the second example of the present disclosure, the micro lenses 154 in at least one sub-pixel can be disposed to be rotated at a specific angle with respect to the first and second directions. Accordingly, the diffraction pattern of the reflected light generated by the regular arrangement of the micro lenses 154 can be offset or minimized, or the diffraction pattern of the reflected light can be irregular or random, so the occurrence of a radial rainbow pattern or a radial circular ring pattern of the reflected light can be suppressed or minimized. Therefore, the image quality of the display device can be improved.

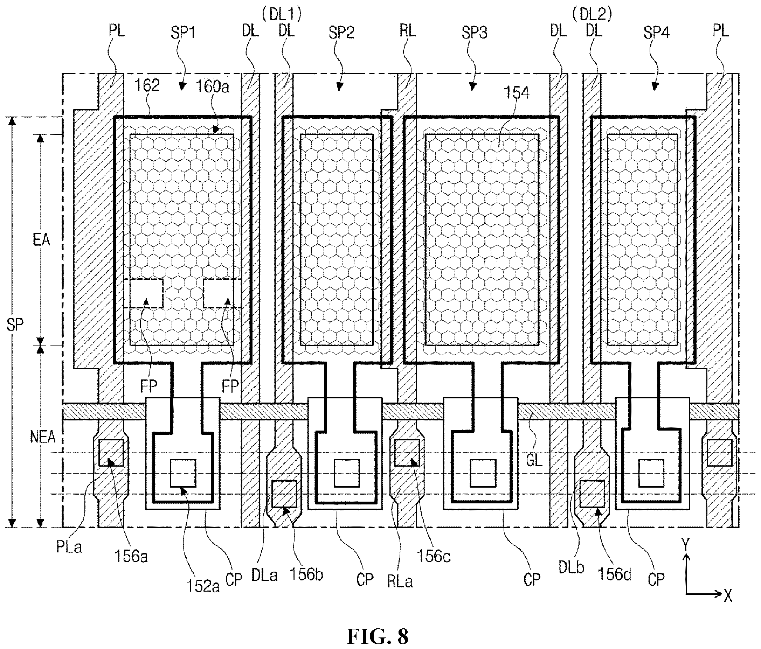

In another example of the present disclosure, the depressed pattern can be provided in all sub-pixels. An organic light-emitting diode display device according to such a third example of present disclosure will be described with reference to FIG. 8.

FIG. 8 is a schematic plan view of an organic light-emitting diode display device according to the third example of the present disclosure. The organic light-emitting diode display device according to the third example of the present disclosure has substantially the same configuration as that of the first example or the second example, except for having a depressed pattern provided in each of the sub-pixels and a structure corresponding thereto. The same or similar parts as the first or second example will be designated by the same or similar references, and explanation for the same parts will be omitted or shortened.

As shown in FIG. 8, in the organic light-emitting diode display device according to the third example of the present disclosure, each of the first, second, third, and fourth sub-pixels SP1, SP2, SP3, and SP4 can have at least one depressed pattern 156 (e.g., 156a, 156b, 156c, and 156d) in the non-emission area NEA.

More particularly, the first, second, third, and fourth sub-pixels SP1, SP2, SP3, and SP4 can have first, second, third, and fourth depressed patterns 156a, 156b, 156c, and 156d in the non-emission area NEA, respectively.

The first, second, third, and fourth depressed patterns 156a, 156b, 156c, and 156d can overlap the lines disposed at one sides of the first, second, third, and fourth sub-pixels SP1, SP2, SP3, and SP4, respectively. Here, the first, second, third, and fourth depressed patterns 156a, 156b, 156c, and 156d can overlap first, second, third, and fourth lines PL, DL1, RL, and DL2 disposed at left sides of the first, second, third, and fourth sub-pixels SP1, SP2, SP3, and SP4, respectively. For example, the first depressed pattern 156a can overlap the power line PL, which is the first line; the second depressed pattern 156b can overlap one data line DL1, which is the second line; the third depressed pattern 156c can overlap the reference line RL, which is the third line; and the fourth depressed pattern 156d can overlap another data line DL2, which is the fourth line. However, the examples of the present disclosure are not limited thereto. Alternatively, the first, second, third, and fourth depressed patterns 156a, 156b, 156c, and 156d can overlap the lines disposed at the left side or the right side of the first, second, third, and fourth sub-pixels SP1, SP2, SP3, and SP4, respectively.

Here, the power line PL, the one data line DL1, the reference line RL, and the another data line DL2 can have first, second, third, and fourth protrusions PLa, DLa, RLa, and DLb corresponding to the first, second, third, and fourth depressed patterns 156a, 156b, 156c, and 156d, respectively. The first, second, third, and fourth protrusions PLa, DLa, RLa, and DLb can have a wider width than other portions of the power line PL, the one data line DL1, the reference line RL, and the another data line DL2, respectively.

The arrangement of the first, second, third, and fourth depressed patterns 156a, 156b, 156c, and 156d can be different in the first, second, third, and fourth sub-pixels SP1, SP2, SP3, and SP4. In this case, at least one of the first, second, third, and fourth depressed patterns 156a, 156b, 156c, and 156d can be disposed on a different straight line from others. In addition, the first, second, third, and fourth depressed patterns 156a, 156b, 156c, and 156d can be disposed on different lines from the contact holes 152a of the first, second, third, and fourth sub-pixels SP1, SP2, SP3, and SP4.

For example, the first and third depressed patterns 156a and 156c can be disposed on the same straight line along the first direction, which is the X direction. The second and fourth depressed patterns 156b and 156d can be disposed on the same straight line along the first direction. The first and third depressed patterns 156a and 156c can be disposed on the different straight line from the second and fourth depressed patterns 156b and 156d.

In addition, a first virtual straight line passing through the centers of the first and third depressed patterns 156a and 156c along the first direction and a second virtual straight line passing through the centers of the second and fourth depressed patterns 156b and 156d along the first direction do not coincide with a third virtual straight line passing through the centers of the contact holes 152a adjacent to each other along the first direction. The first, second, and third virtual straight lines can be spaced apart from each other along the second direction.

However, the examples of the present disclosure are not limited thereto, and the arrangement of the first, second, third, and fourth depressed patterns 156a, 156b, 156c, and 156d can be changed.

The first, second, third, and fourth depressed patterns 156a, 156b, 156c, and 156d can be used for monitoring the micro lenses 154. The method of forming the first, second, third, and fourth depressed patterns 156a, 156b, 156c, and 156d and the micro lenses 154 and the monitoring process can be substantially the same as those of FIGS. 6A to 6D.

As such, since the organic light-emitting diode display device according to the third example of the present disclosure can include at least one depressed pattern 156a, 156b, 156c, and 156d disposed in the non-emission area NEA of each sub-pixel SP1, SP2, SP3, and SP4 and overlapping the line, the pattern consistency of the micro lenses 154 in the opening 160a can be improved, and the micro lenses 154 can be manufactured and managed more precisely for each sub-pixel SP1, SP2, SP3, and SP4, thereby providing the display device of a better quality.

In the organic light-emitting diode display device of the examples of the present disclosure, the plurality of micro lenses can be provided in the emission area of each sub-pixel, so the light extraction efficiency can be improved.

In addition, the depressed pattern can be formed in the non-emission area through the same process as the micro lenses, thereby efficiently manufacturing and managing the micro lenses. Specially, it is possible to manage the process for forming an optimal structure that can improve the light extraction efficiency through monitoring of the micro lenses. By using this, the efficiency of the organic light-emitting diode display device can be improved, and the power consumption can be reduced due to the improved efficiency, thereby implementing the low power consumption.

Moreover, the production energy can be reduced and the process optimization can be implemented by the rework and process management through the monitoring. Furthermore, the production hazards and regulated substances can be reduced, and thus it can be helpful for recycling.

Additionally, by placing the depressed pattern over the line made of a metal material, the depressed pattern can be easily measured using the reflectance during measurement, and the measurement noise can be reduced due to the flatness of the line, which is relatively higher than that of an insulation layer, thereby improving the consistency. The depressed pattern can be spaced apart from and disposed on a different straight line from the contact hole, thereby reducing the probability of mismeasurement (e.g., measuring the contact hole instead of the depressed pattern can be avoided or minimized).

Further, the depressed pattern can be provided in each sub-pixel, the pattern consistency of the micro lenses in the opening can be improved, and the micro lenses can be manufactured and managed more precisely for each sub-pixel.

In addition, by rotating the micro lenses in at least one sub-pixel, the rainbow pattern and/or the circular ring pattern occurring due to the regular arrangement can be prevented or minimized, thereby improving the image quality of the display device.

Moreover, the flat portions where the micro lenses are not substantially placed can be provided in the emission area EA, and the boundary of the opening of the bank can be disposed over the flat portions FP. As such, the size of the opening of the bank and the distance between the openings can be accurately measured without distortion of the gray level due to the present of the flat portions. This ensures that the sufficient number of micro lenses are present in each sub-pixel based on the measured sizes of the openings.

Further examples are set out in the numbered clauses below:
1. An organic light-emitting diode display device, comprising: a substrate including a plurality of sub-pixels associated with one pixel, each sub-pixel having an emission area and a non-emission area; a plurality of first conductive lines and a second conductive line over the substrate, wherein the second conductive line crosses over the plurality of first conductive lines to define the plurality of sub-pixels; a circuit portion in the non-emission area of each sub-pixel, and including a thin film transistor in each sub-pixel; an overcoat layer over the thin film transistors, and including a plurality of micro lenses in the emission area of each sub-pixel; and a light-emitting diode in the emission area of each sub-pixel over the overcoat layer, and connected to the corresponding thin film transistor, wherein for a first sub-pixel among the plurality of sub-pixels, the overcoat layer has a depressed pattern corresponding to the non-emission area of the first sub-pixel and overlaps one of the plurality of first conductive lines.
2. The organic light-emitting diode display device of clause 1, wherein a size of the depressed pattern is greater than a size of the micro lens in the first sub-pixel.
3. The organic light-emitting diode display device of clause 1 or clause 2, wherein a portion of the first conductive line overlapping the depressed pattern has a wider width than other portions of the same first conductive line.
4. The organic light-emitting diode display device of any one of clauses 1-3, wherein the plurality of first conductive lines include at least two of a power line, one or more data lines, and a reference line, the second conductive line is a gate line, and the depressed pattern overlaps the power line.
5. The organic light-emitting diode display device of clause 4, wherein a width of the power line is wider than a width of any one of the one or more data lines and the reference line.
6. The organic light-emitting diode display device of any one of the preceding clauses, wherein for the first sub-pixel, the overcoat layer further includes a contact hole corresponding to the thin film transistor, the light-emitting diode is electrically connected to the thin film transistor through the contact hole, and the depressed pattern and the contact hole are disposed on different straight lines extending along an extending direction of the second conductive line.
7. The organic light-emitting diode display device of any one of the preceding clauses, wherein for the first sub-pixel, the emission area has two flat portions where a top surface of the overcoat layer is flat, and the two flat portions are disposed at both sides of the emission area facing each other and are on a same straight line.
8. The organic light-emitting diode display device of clause 7, further comprising a bank having an opening corresponding to the emission area of the first sub-pixel, wherein two side surfaces of the bank with the opening interposed therebetween and facing each other are disposed over the two flat portions, respectively.
9. The organic light-emitting diode display device of any one of the preceding clauses, wherein the plurality of sub-pixels include the first sub-pixel, a second sub-pixel, a third sub-pixel and a fourth sub-pixel, which are provided over the substrate along a first direction, and
   wherein the micro lenses in at least one of the first, second, third, and fourth sub-pixels are rotated at a rotation angle, so that a line connecting centers of the micro lenses adjacent to each other has a specific angle with respect to the first direction.
10. The organic light-emitting diode display device of clause 9, wherein the rotation angle of the micro lenses is greater than 0 degrees and is equal to or less than 60 degrees.
11. The organic light-emitting diode display device of any one of the preceding clauses, wherein the plurality of sub-pixels include the first sub-pixel, a second sub-pixel, a third sub-pixel, and a fourth sub-pixel, which are sequentially provided over the substrate along a first direction, wherein the plurality of first conductive lines include four first conductive lines disposed at one sides of the first, second, third, and fourth sub-pixels, respectively, and wherein the overcoat layer has first, second, third, and fourth depressed patterns overlapping the four first conductive lines, respectively.
12. The organic light-emitting diode display device of clause 11, wherein at least one of the first, second, third, and fourth depressed patterns is disposed on a different straight line from another one of the first, second, third, and fourth depressed patterns.
13. An organic light-emitting diode display device, comprising: a pixel including a plurality of sub-pixels over a substrate, wherein each sub-pixel includes an emission area and a non-emission area; a plurality of thin film transistors respectively provided in the non-emission areas of the plurality of sub-pixels; a plurality of color filters respectively provided in the emission areas of the plurality of sub-pixels; an overcoat layer provided over the plurality of color filters and the plurality of thin film transistors; a bank including a plurality of openings, the plurality of openings respectively provided in the emission areas of the plurality of sub-pixels; and a plurality of micro lenses provided at top surfaces of the overcoat layer, wherein in a first sub-pixel among the plurality of sub-pixels, micro-lenses that are provided at the top surfaces of the overcoat layer do not fill the entire opening corresponding to the first sub-pixel, while in all other sub-pixels, micro-lenses provided at the top surfaces of the overcoat layer fill the entire openings corresponding to the all other sub-pixels.
14. The organic light-emitting diode display device of clause 13, wherein in the first sub-pixel, the overcoat layer exposed by the opening includes two flat portions provided at opposite side ends of the opening with the micro-lenses provided between the two flat portions.
15. The organic light-emitting diode display device of clause 13 or 14, further comprising: a plurality of first conductive lines extending in one direction and a second conductive line crossing over the plurality of first conductive lines over the substrate, and defining the plurality of sub-pixels, wherein for the first sub-pixel, the overcoat layer further includes a depressed pattern at a top surface of the overcoat layer in the non-emission area, the depressed pattern overlapping one of the plurality of first conductive lines.
16. The organic light-emitting diode display device of clause 15, wherein the one of the plurality of first conductive lines overlapped with the depressed pattern in the first sub-pixel is a power line.
17. The organic light-emitting diode display device of clause 15 or 16, wherein the depressed pattern in the first sub-pixel is mis-aligned with and spaced apart from a contact hole of the thin film transistor in the first sub-pixel.
18. The organic light-emitting diode display device of clause 13, further comprising: a plurality of first conductive lines extending in one direction and a second conductive line crossing over the plurality of first conductive lines over the substrate, and defining the plurality of sub-pixels, wherein the overcoat layer further includes a plurality of depressed patterns provided respectively at top surfaces of the overcoat layer in the non-emission areas of the plurality of sub-pixels, and wherein the plurality of depressed patterns overlap respectively some of the plurality of first conductive lines.
19. The organic light-emitting diode display device of clause 18, wherein the plurality of first conductive lines overlapped with the plurality of depressed patterns include at least two of a power line, a data line and a reference line.
20. The organic light-emitting diode display device of clause 18 or 19, wherein at least one of the plurality of depressed patterns is mis-aligned with another one of the plurality of depressed patterns, or wherein the plurality of depressed patterns are mis-aligned with and spaced apart from contact holes of the plurality of thin film transistors in the non-emission areas of the plurality of sub-pixels.

It will be apparent to those skilled in the art that various modifications and variations can be made in the display device of the present disclosure without departing from the technical idea or scope of the disclosure. Thus, it is intended that the present disclosure cover the modifications and variations of this disclosure provided they come within the scope of the appended claims and their equivalents.

## Claims

1. An organic light-emitting diode display device, comprising:
a substrate including a plurality of sub-pixels associated with one pixel, each sub-pixel having an emission area and a non-emission area;
a plurality of first conductive lines and a second conductive line over the substrate, wherein the second conductive line crosses over the plurality of first conductive lines to define the plurality of sub-pixels;
a circuit portion in the non-emission area of each sub-pixel, and including a thin film transistor in each sub-pixel;
an overcoat layer over the thin film transistors, and including a plurality of micro lenses in the emission area of each sub-pixel; and
a light-emitting diode in the emission area of each sub-pixel over the overcoat layer, and connected to the corresponding thin film transistor,
wherein for a first sub-pixel among the plurality of sub-pixels, the overcoat layer has a depressed pattern corresponding to the non-emission area of the first sub-pixel and overlaps one of the plurality of first conductive lines.

2. The organic light-emitting diode display device of claim 1, wherein a size of the depressed pattern is greater than a size of the micro lens in the first sub-pixel; or optionally
wherein a portion of the first conductive line overlapping the depressed pattern has a wider width than other portions of the same first conductive line.

3. The organic light-emitting diode display device of claim 1, wherein the plurality of first conductive lines include at least two of a power line, one or more data lines, and a reference line,
the second conductive line is a gate line, and
the depressed pattern overlaps the power line; and optionally
wherein a width of the power line is wider than a width of any one of the one or more data lines and the reference line.

4. The organic light-emitting diode display device of any one of the preceding claims, wherein for the first sub-pixel,
the overcoat layer further includes a contact hole corresponding to the thin film transistor,
the light-emitting diode is electrically connected to the thin film transistor through the contact hole, and
the depressed pattern and the contact hole are disposed on different straight lines extending along an extending direction of the second conductive line.

5. The organic light-emitting diode display device of any one of the preceding claims, wherein for the first sub-pixel,
the emission area has two flat portions where a top surface of the overcoat layer is flat, and
the two flat portions are disposed at both sides of the emission area facing each other and are on a same straight line.; and optionally
further comprising a bank having an opening corresponding to the emission area of the first sub-pixel,
wherein two side surfaces of the bank with the opening interposed therebetween and facing each other are disposed over the two flat portions, respectively.

6. The organic light-emitting diode display device of any one of the preceding claims, wherein the plurality of sub-pixels include the first sub-pixel, a second sub-pixel, a third sub-pixel and a fourth sub-pixel, which are provided over the substrate along a first direction, and
wherein the micro lenses in at least one of the first, second, third, and fourth sub-pixels are rotated at a rotation angle, so that a line connecting centers of the micro lenses adjacent to each other has a specific angle with respect to the first direction.

7. The organic light-emitting diode display device of claim 6, wherein the rotation angle of the micro lenses is greater than 0 degrees and is equal to or less than 60 degrees.

8. The organic light-emitting diode display device of any one of the preceding claims, wherein the plurality of sub-pixels include the first sub-pixel, a second sub-pixel, a third sub-pixel, and a fourth sub-pixel, which are sequentially provided over the substrate along a first direction,
wherein the plurality of first conductive lines include four first conductive lines disposed at one sides of the first, second, third, and fourth sub-pixels, respectively, and
wherein the overcoat layer has first, second, third, and fourth depressed patterns overlapping the four first conductive lines, respectively.

9. The organic light-emitting diode display device of claim 8, wherein at least one of the first, second, third, and fourth depressed patterns is disposed on a different straight line from another one of the first, second, third, and fourth depressed patterns.

10. An organic light-emitting diode display device, comprising:
a pixel including a plurality of sub-pixels over a substrate, wherein each sub-pixel includes an emission area and a non-emission area;
a plurality of thin film transistors respectively provided in the non-emission areas of the plurality of sub-pixels;
a plurality of color filters respectively provided in the emission areas of the plurality of sub-pixels;
an overcoat layer provided over the plurality of color filters and the plurality of thin film transistors;
a bank including a plurality of openings, the plurality of openings respectively provided in the emission areas of the plurality of sub-pixels; and
a plurality of micro lenses provided at top surfaces of the overcoat layer,
wherein in a first sub-pixel among the plurality of sub-pixels, micro-lenses that are provided at the top surfaces of the overcoat layer do not fill the entire opening corresponding to the first sub-pixel, while in all other sub-pixels, micro-lenses provided at the top surfaces of the overcoat layer fill the entire openings corresponding to the all other sub-pixels.

11. The organic light-emitting diode display device of claim 10, wherein in the first sub-pixel, the overcoat layer exposed by the opening includes two flat portions provided at opposite side ends of the opening with the micro-lenses provided between the two flat portions.

12. The organic light-emitting diode display device of claim 10 or 11, further comprising:
a plurality of first conductive lines extending in one direction and a second conductive line crossing over the plurality of first conductive lines over the substrate, and defining the plurality of sub-pixels,
wherein for the first sub-pixel, the overcoat layer further includes a depressed pattern at a top surface of the overcoat layer in the non-emission area, the depressed pattern overlapping one of the plurality of first conductive lines.

13. The organic light-emitting diode display device of claim 15, wherein the one of the plurality of first conductive lines overlapped with the depressed pattern in the first sub-pixel is a power line; or optionally
wherein the depressed pattern in the first sub-pixel is mis-aligned with and spaced apart from a contact hole of the thin film transistor in the first sub-pixel.

14. The organic light-emitting diode display device of claim 10, further comprising:
a plurality of first conductive lines extending in one direction and a second conductive line crossing over the plurality of first conductive lines over the substrate, and defining the plurality of sub-pixels,
wherein the overcoat layer further includes a plurality of depressed patterns provided respectively at top surfaces of the overcoat layer in the non-emission areas of the plurality of sub-pixels, and
wherein the plurality of depressed patterns overlap respectively some of the plurality of first conductive lines.

15. The organic light-emitting diode display device of claim 14, wherein the plurality of first conductive lines overlapped with the plurality of depressed patterns include at least two of a power line, a data line and a reference line; or optionally
wherein at least one of the plurality of depressed patterns is mis-aligned with another one of the plurality of depressed patterns, or
wherein the plurality of depressed patterns are mis-aligned with and spaced apart from contact holes of the plurality of thin film transistors in the non-emission areas of the plurality of sub-pixels.
